# EUROPÄISCHE PATENTSCHRIFT

(11) **EP 2 638 444 B1**
(45) Veröffentlichungstag und Bekanntmachung des Hinweises auf die Patenterteilung: **25.05.2016**
(21) Anmeldenummer: 11748275.2
(22) Anmeldetag: 19.08.2011
(51) Int. Cl.: G05B 23/02

(54) **INTELLIGENTE VISUALISIERUNG BEI DER ÜBERWACHUNG VON PROZESS- UND/ODER ANLAGEGRÖSSEN**
INTELLIGENT VISUALISATION IN THE MONITORING OF PROCESS AND/OR SYSTEM VARIABLES
VISUALISATION INTELLIGENTE DANS LA SURVEILLANCE DE GRANDEURS DE PROCESSUS ET/OU D'INSTALLATIONS

(30) Priorität: 13.11.2010 EP 10014593
(43) Veröffentlichungstag der Anmeldung: 18.09.2013
(73) Patentinhaber: ABB Technology AG, 8050 Zürich (CH)
(72) Erfinder: CHIOUA, Moncef, 69115 Heidelberg (DE); HOLLENDER, Martin, 69221 Dossenheim (DE)
(74) Vertreter: Kock, Ina
(86) Internationale Anmeldenummer: PCT/EP2011/004175
(87) Internationale Veröffentlichungsnummer: WO 2012/062387

(56) Entgegenhaltungen:
- WO-A1-2008/145154
- US-A1- 2006 136 175
- US-A1- 2009 177 439
- US-B1- 6 564 119
- US-B1- 7 000 193

## Beschreibung

Die Erfindung betrifft ein Verfahren und ein System zur intelligenten Visualisierung bei der Überwachung von Prozess- und/oder Anlagegrößen, insbesondere von sogenannten Massedaten, also einer Vielzahl von Prozess- und/oder Verfahrensdaten, welche während des Betriebes technischer Anlagen oder dem Ablauf technischer Prozesse auftreten. Die Erfindung ist zur grafischen Darstellung von Prozessdaten, insbesondere von Massedaten, auf einer Anzeigevorrichtung, nachfolgend auch Display genannt, vorzugsweise einem Bildschirm, in der in der Anlagentechnik, Leittechnik und Verfahrensplanung geeignet.

Sogenannte Massendatendisplays können eine große Zahl normierter Prozessgrößen auf vergleichsweise wenig Bildschirmplatz darstellen. Bei großen technischen Anlagen, beispielsweise einem Kraftwerk, ist es häufig nicht einfach möglich zu spezifizieren, welche der oftmals vielen tausend Prozess- und Anlagegrößen für eine Visualisierung wichtig sind. Deshalb sollte die Konfiguration und Kalibrierung von Massendatendisplays durch automatisierte Verfahren möglichst gut unterstützt werden, um die Vorteile einer übersichtlichen und aussagekräftigen Darstellung möglichst gut nutzen zu können. Menschliches Wahmehmungsvermögen von jedwelchen Zeichen oder Mustern reagiert besonders sensibel auf deren Veränderungen und Abweichungen sowie auf Unregelmäßigkeiten.

Diese Tatsache wird benutzt bei entsprechenden Anzeigen wie der Anzeige von sogenannten Massedaten, also einer Vielzahl von Daten auf einem Display. Dabei ist es von Bedeutung, dass während des ungestörten Normalbetriebes einer technischen Anlage oder eines technischen Prozesses die Anzeige der Verfahrensparameter sowie der Zustände der Anlagenkomponenten, zu denen auch die Messstellen innerhalb der technischen Anlage zählen, so regelmäßig wie möglich erfolgt und sich so wenig wie möglich für das menschliche Wahmehmungsvermögen verändert.

Dennoch kann angesichts der Begleitumstände des Verfahrens beziehungsweise der Zustände der Anlagenkomponenten und Messstellen infolge von Rauschen ein gewisser Grad an Unruhe und Unregelmäßigkeiten auch während des Normalbetriebs der Anlage bzw. dem Ablauf des Verfahrens ohne irgendwelche Störungen oder äußere Einflussfaktoren nicht vermieden werden.

Je größer die Unregelmäßigkeit und Unruhe infolge des Rauschens ist, desto weniger brauchbar ist die Anzeige, beispielsweise auf einem Display eines Bildschirms der übergeordneten Steuerungsebene eines Automatisierungssystems.

Obgleich von der Anzeige sogenannter Massedaten auf einem Display viele Vorteile resultieren wegen des hohen Grades an Abstraktion, tendieren heute viele Anlagenfahrer großer technischer Anlagen, wie beispielsweise in einem Kraftwerk zur Wiedergabe von realen Prozess- und/oder Anlagekennwerten auf dem Display der Leitwarte.

Oftmals enthalten diese Anzeigen über die Prozess- und Anlagenzustände nur relativ wenige Prozess- und/oder Anlagengrößen. Typischerweise werden auf den Anlagenübersichtsbildem maximal einige hundert der wichtigsten Werte angezeigt Der Kostenaufwand für deren Überwachung steigt deutlich mit der Anzahl der zur Verfügung stehenden Prozess- und/oder Anlagedaten an. Limitierend ist dabei vor allem die Aufnahmefähigkeit der Anlagenfahrer und der zur Verfügung stehende Bildschirmplatz, da Menschen nur eine begrenzte Anzahl von Werten parallel überwachen können. Wertet man Störfälle retrospektiv aus, stellt sich oftmals heraus, dass für eine frühzeitige Erkennung der sich anbahnenden Störung eine bestimmte Prozessgröße hätte angezeigt werden müssen, die bislang als relativ unwichtig galt. Massendatendisplays bieten die Möglichkeit, eine große Anzahl von Werten systematisch anzuzeigen.

Im Falle, dass eine der Prozess- und/oder Anlagengrößen periodischen Schwingungen unterliegt, bedeutet dies entsprechende Unschärfen in ihrer Darstellung, wobei Schwingungen häufig nicht als solche durch den Anlagenfahrer der Anlage erkannt werden und daher oft als Versatz interpretiert werden. Schnelle Schwingungen der Anlagen-/ oder Prozessgrößen führen zu Unruhe im Massendatendisplay.

US 2006/0136175 zeigt ein Verfahren zur Visualisierung von Anlagedaten.

Ausgehend von diesen im Stand der Technik beobachteten Nachteilen ist es Aufgabe der Erfindung, ein Verfahren zur intelligenten Visualisierung bei der Überwachung von Prozess- und/oder Anlagegrößen, insbesondere von sogenannten Massedaten, anzugeben, welches die vorstehend genannten Nachteile vermeidet und darüber hinaus insbesondere den Aufwand für eine Kalibrierung auf einen vernünftigen und für den Bediener der Anlage überschaubaren Rahmen beschränkt, wobei während des Normalbetriebes Unruhe und Unregelmäßigkeiten in der Anzeige der Massedaten deutlich unterhalb des Grenzwertes liegen, bei welchem eine Anzeige der Prozess- und/oder Anlagegrößen unbrauchbar wird.

Dazu wird das Verhalten der Signale in der Vergangenheit analysiert und für eine zukünftig optimierte Visualisierung genutzt. Kontinuierlich laufende Online-Algorithmen unterstützen dabei die Anlagenfahrer, indem sie Abweichungen von historisch beobachteten Signalmustern erkennen und entsprechend hervorheben.

Ferner sollte ein schnelles Umschalten von einer normierten abstrakten Darstellung auf eine herkömmliche Wiedergabe der Prozess- und/oder Anlagegrößen bzw. Prozess- und/oder Anlagedaten, wie eine Trendanzeige vorgesehen sein.

Diese Aufgabe wird erfindungsgemäß durch ein Verfahren der eingangs genannten Art mit den im Anspruch 1 angegebenen Merkmalen gelöst. Vorteilhafte Ausgestaltungen und Verbesserungen des erfindungsgemäßen Verfahrens sowie ein System zur Ausführung des Verfahrens sind in weiteren Ansprüchen und in der Beschreibung angegeben.

Demgemäß ist erfindungsgemäß vorgesehen, dass zur intelligenten Visualisierung bei der Überwachung von Prozess- und/oder Anlagedaten, insbesondere von sogenannten Massedaten, die beispielsweise Messwerte, Prozessgrößen und/oder Zustandsmeldungen einer technischen Anlage oder eines technischen Prozesses umfassen, die Erkenntnis ausgenutzt wird, dass sich viele Prozess- und/oder Anlagedaten aus verschiedenen Gründen nicht ändern, und hierbei die Annahme gilt, dass Prozess- und/oder Anlagedaten sich in der Zukunft nicht ändern werden, wenn sie sich zumindest für einen gewissen Zeitraum in der Vergangenheit nicht geändert haben, wobei eine große Anzahl von diesen sogenannten stillen Signalen in einer einzigen Ansicht bzw. Darstellungsform, vorzugsweise dem Display eines Bildschirms zusammengefasst werden. Ein Beispiel hierfür ist der Öffnungsgrad eines Sicherheitsventils, das normalerweise geschlossen ist. Für den Normalbetrieb der Anlage spielt dieser - immer gleiche - Öffnungsgrad keine Rolle, öffnet das Ventil aber aufgrund außergewöhnlicher Umstände doch, so ist dies eine wichtige Information, die dem Anlagenfahrer explizit dargestellt werden sollte.

Erfindungsgemäß werden die stillen Signale, im vorab genannten Beispiel das geschlossene Ventil, mittels geeigneter Algorithmen überwacht, und im Falle, dass ein Signal aktiv wird, also das Ventil geöffnet wird, wird dieses Signal im Display hervorgehoben angezeigt und/oder gemeldet.

In einer Ausgestaltung der Erfindung wird nur dann ein Signal als "aktiv" angesehen bzw. gesetzt, wenn eine geschätzte Varianz einer Prozess- und/oder Anlagengröße einen vorkonfigurierten Schwellwert überschreitet.

In einer weiteren Ausgestaltung des erfindungsgemäßen Verfahrens wird eine Ähnlichkeits-Metrik definiert und ein Algorithmus, wie beispielsweise eine Korrelation oder Principal Component Analysis (PCA) zur Auswertung der Ähnlichkeits-Metrik für alle Prozess- und/oder Anlagedaten angewendet.

Vorzugsweise werden alle Prozess- und/oder Anlagedaten, die als ausreichend ähnlich ermittelt worden sind, in einem einzigen Display bzw. in einer einzigen Ansicht angezeigt, wobei vorgesehen sein kann, dass die Ähnlichkeits-Metrik kontinuierlich regelmäßig mittels eines Auswertemoduls ausgewertet wird und Signale, die nicht mehr den Ähnlichkeits-Kriterien gehorchen, automatisch mittels eines Filtermoduls herausgefiltert und in einer separaten Darstellung bereitgestellt und/oder angezeigt werden.

Weiterhin werden in einer vorteilhaften Ausgestaltung des erfindungsgemäßen Verfahrens die Prozess- und/oder Anlagedaten online bezüglich dominanter Schwingungen mittels eines Analysemoduls analysiert, so dass beispielsweise detektierte dominante Schwingungen vom Signal entfernt und separat ausgewiesen werden.

Wie eingangs bereits angesprochen, betrifft die Erfindung auch eine Vorrichtung beziehungsweise ein System zur intelligenten Visualisierung bei der Überwachung von Prozess- und/oder Anlagedaten, insbesondere von Massedaten, welche bei technischen Verfahren beziehungsweise beim Betrieb technischer Anlagen üblich sind.

Erfindungsgemäß benutzt dieses Anzeigesystem beziehungsweise diese Anzeigevorrichtung zur intelligenten Visualisierung bei der Überwachung der Prozess- und/oder Anlagedaten eine einzige Ansicht bzw. Darstellungsform zur Darstellung einer Vielzahl von stillen oder normierten Signalen mittels einer Hervorhebung, Meldung und/oder Anzeige.

Dabei erweist es sich als vorteilhaft, dass eine Überwachung der Signale mittels eines im System integrierten Überwachungsmoduls vorgesehen ist, wobei im Falle eines aktiven Signals dieses Signal vom Überwachungsmodul detektierbar ist und zu einer Ansicht des Displays übertragbar und/oder dort darstellbar ist.

In einer Ausgestaltung des erfindungsgemäßen Systems ist ein Schwellwertüberwachungsmodul vorgesehen, welches ein aktives Signal auswählt, wenn eine geschätzte Varianz der betreffenden Prozess- und/oder Anlagendaten einen vorkonfigurierten Schwellwert überschreitet.

Gemäß einer vorteilhaften Ausgestaltung der Erfindung ist das System dadurch gekennzeichnet, dass die Erstellung einer Ähnlichkeits-Metrik und deren Auswertung für alle Prozess- und/oder Anlagengrößen mittels eines vorgegebenen Algorithmus ausführbar ist und/oder alle Signale, die nicht mehr den Ähnlichkeits-Kriterien gehorchen, automatisch in einer Summendarstellung zur Anzeige bzw. zur Meldung kommen.

Entsprechend dem Verfahren ist auch beim erfindungsgemäßen System vorgesehen, dass alle Massedaten, die als ausreichend ähnlich ermittelt worden sind, in einem einzigen Display zur Anzeige kommen.

Erfindungsgemäß werden während der vorausgehenden Offline- Engineering- Phase vorhandene historische Prozessdaten, beispielsweise aus einem Plant Information Management System (PIMS) ausgewertet.

Sind - wie beispielsweise bei einer neu errichteten Anlage - bisher nur wenige historische Prozessdaten verfügbar, so können die beschriebenen Anzeigen zunächst nicht mit höchster Qualität funktionieren. Sobald zu einem späteren Zeitpunkt genügend historische Prozessdaten verfügbar sind, wird eine Kalibrierung der Anzeigen erneut durchgeführt.

Die gefundenen Charakteristika werden dann verwendet, um die Ansicht oder Darstellungsform zur Anzeige der Massedaten zu optimieren. Hierbei kann nach verschiedenen Kriterien vorgegangen werden, die in den nachfolgenden Figuren dargestellt sowie näher erläutert werden.

Es zeigen:
- **Fig. 1**: eine beispielhafte Summendarstellung stiller Signale,
- **Fig. 2**: eine beispielhafte Summendarstellung ähnlicher Signale,
- **Fig. 3**: eine beispielhafte detaillierte Schwingungsanzeige, und
- **Fig. 4**: eine beispielhafte Darstellung von Massedaten auf einem Display eines Bildschirms der übergeordneten Steuerungsebene eines Automatisierungssystems.

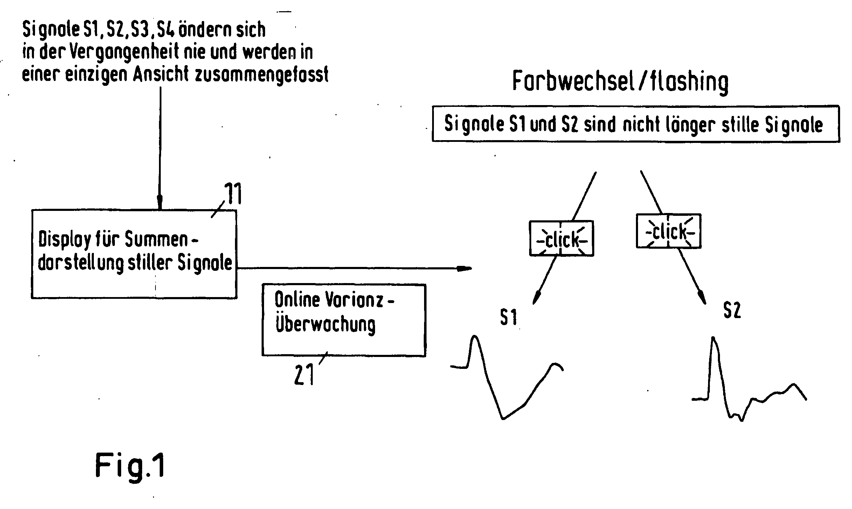

**Fig.** 1 zeigt beispielhaft eine Summendarstellung stiller Signale S1, S2, S3, S4. Ausgangspunkt ist dabei die Betrachtung einer Gesamtmenge von gemessenen Prozess- und/oder Anlagengrößen, wobei sich viele Prozess- und/oder Anlagengrößen aus verschiedenen Gründen nicht ändern. Diese Größen können Komponenten betreffen, die im Normalbetrieb der Anlage immer gleich arbeiten, wie beispielsweise Überdruckventile. Für die Konfigurationen von Massendatendisplays relevant sind aber auch Messungen mit defekten Sensoren. Es gilt hierbei die Annahme, dass, wenn sich die jeweiligen Prozess- und/oder Anlagengrößen, nachfolgend auch als stille Signale S1, S2, S3, S4 bezeichnet, nicht für einen gewissen, vorab definierten Zeitraum in der Vergangenheit geändert haben, es wahrscheinlich ist, dass sie sich auch in der Zukunft nicht ändern werden. Ändert sich ein solches Signal aber doch, so ist diese Tatsache vielfach von besonderer Bedeutung für die Anlagenfahrer.

Eine große Anzahl von stillen Signalen S1, S2, S3, S4 können somit in einer einzigen Ansicht (Display) bzw. Darstellungsform 11 zusammengefasst werden.

Die stillen Signale S1, S2, S3, S4 werden erfindungsgemäß mittels eines Überwachungsmoduls 21, welches in dem zur Summendarstellung gehörenden Anzeigensystem integriert sein kann und eine Varianzüberwachung durchführt, überwacht und wenn ein Signal S1, S2 aktiv wird, beispielsweise weil die geschätzte Varianz einen vorkonfigurierten Schwellwert überschreitet, dann wird diese Tatsache, beispielsweise mittels eines Farbwechsels des angezeigten Signals, im Display angezeigt. Das Überwachungsmodul zur Varianzüberwachung 21 dient dann kontinuierlich zur Online- Überwachung.

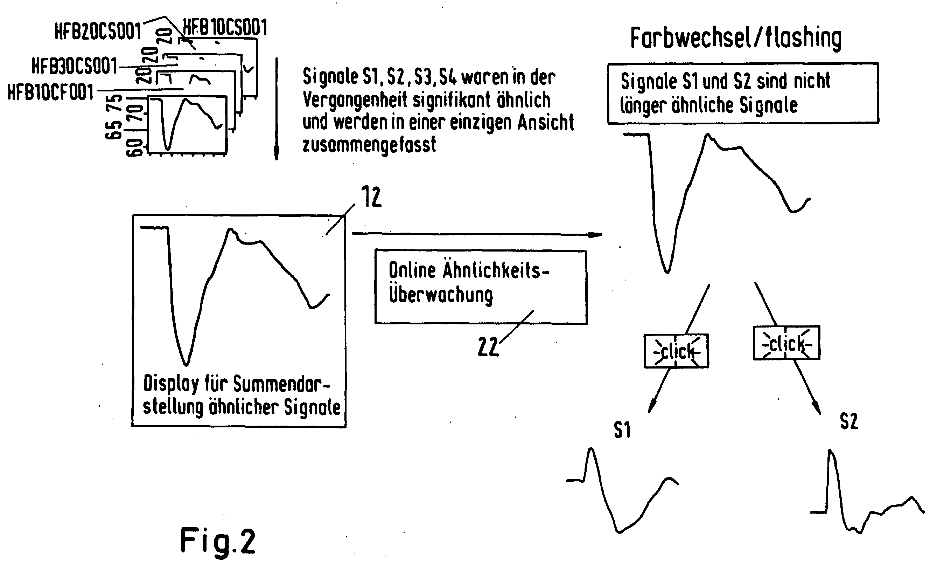

In **Fig.** 2 ist beispielhaft eine Summendarstellung ähnlicher Signale S1, S2, S3, S4 gezeigt. Viele Prozess- und/oder Anlagengrößen verhalten sich ähnlich, zum Beispiel beim Vorhandensein von redundanten Messstellen. Solange sich die Messwerte der redundanten Messstellen gleich verhalten, also keine Abweichungen voneinander zeigen, besteht wenig Anlass, um alle Messwerte zu zeigen. Somit wird in einem ersten Schritt eine Ähnlichkeits-Metrik definiert und ein angemessener Algorithmus, wie beispielsweise Korrelation oder Principal Component Analysis (PCA), zur Auswertung dieser Metrik auf alle relevanten Prozess- und/oder Anlagengrößen angewendet.

Alle Prozess- und/oder Anlagengrößen bzw. Prozess- und/oder Anlagesignale S1, S2, S3, S4, die dabei als ausreichend ähnlich ermittelt worden sind, werden dann in einem einzigen Display 12 angezeigt. Diese Ähnlichkeits-Metrik wird regelmäßig mittels eines vorgesehenen Auswertemoduls 22 ausgewertet und Signale S1, S2, die nicht mehr den Ähnlichkeits-Kriterien entsprechen, werden automatisch, beispielsweise mittels eines Farbumschlages, angezeigt. Das Auswertemodul 22 arbeitet dabei, wie vorab für das Überwachungsmodul 21 beschrieben, als OnlineÄhnlichkeitsüberwachungsmodul.

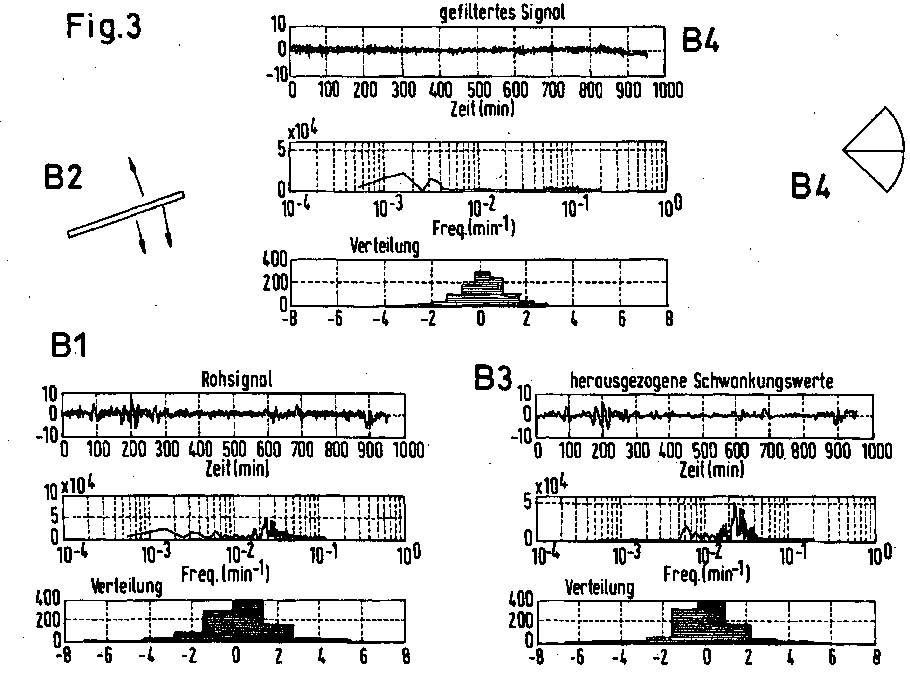

**Fig.** 3 zeigt beispielhaft eine detaillierte Schwingungsanzeige, wobei die Prozessund/oder Anlagesignale online für dominante Schwingungen mittels eines Analysemoduls so analysiert werden, dass die zuvor detektierten dominanten Schwingungen von entsprechenden Signal abgezogen und separat ausgewiesen werden. Die restlichen Signalkomponenten bewegen sich weniger, da sie weniger Variabilität aufweisen. Daher hilft die Darstellung, mehr regelmäßigere und stabile Muster zu zeigen. Die explizite Darstellung von Schwingungen hilft dem Anlagenfahrer, auch eine langsame Schwingung zu erkennen.

In der **Fig.** 3 sind dargestellt Signalverläufe für ein ungefiltertes Rohsignal B1, für ein Signal B3 mit dem Anteil der dominanten Schwingungen und für ein Signal B4, sowie eine Massendatenanzeige B2.

Das ungefilterte Rohsignal B1 besitzt eine starke Variabilität, was in der Massendatenanzeige B2 zu einer starken Unruhe führen würde. Das Signal B3 zeigt den Anteil der dominanten Schwingungen, welcher im Rohsignal B1 enthalten ist. Diese Schwingungen werden aus dem Rohsignal B1 entfernt und führen dann zu dem Signalverlauf B4, der auch als gefiltertes Signal bezeichnet wird. Das Signal B4 hat deutlich weniger Variabilität, das Massendatendisplayelement verhält sich deutlich ruhiger. Die Schwingung des Signals B3 wird im Massendatendisplay visualisiert, indem ein Kreisausschnitt gezeigt wird, der sich je stärker öffnet, je stärker die Schwingung ist. Anstelle eines sich stark hin- und her- bewegenden Strichs, wie als B2 gezeigt, erhält man einen Kreisausschnitt B4 der sich nur wenig bewegt. Dies erzeugt ein ruhigeres Bild, zum anderen werden die Schwingungen durch den Kreisausschnitt B4 explizit sichtbar gemacht.

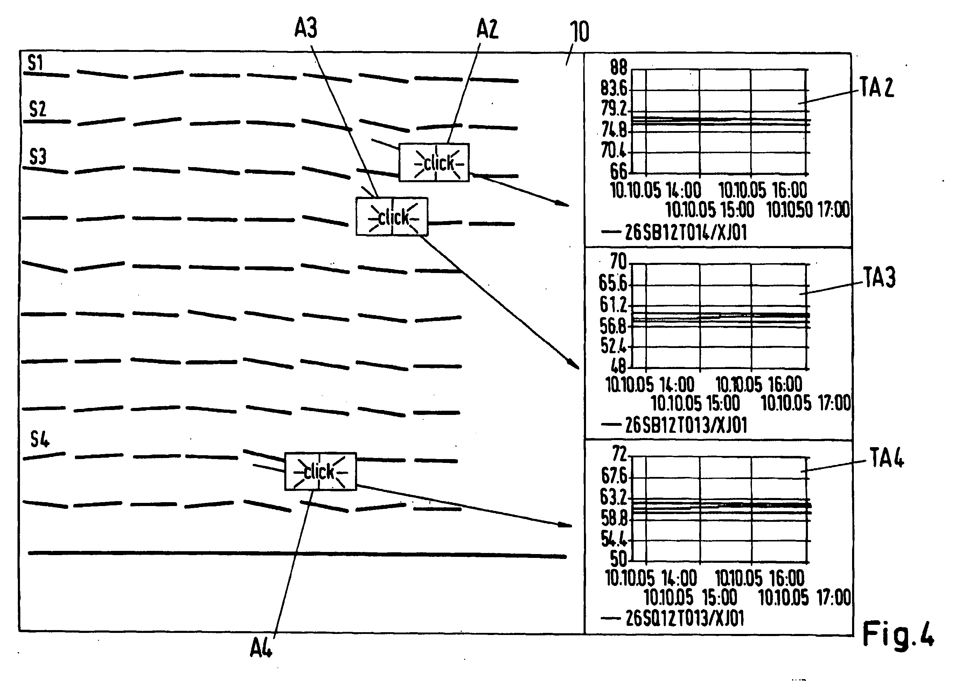

**Fig.** 4 zeigt eine erfindungsgemäße Darstellung von Massedaten 10 auf einem Display eines Bildschirms der übergeordneten Steuerungsebene eines Automatisierungssystems, wobei die Signale S1, S2, S3, S4... normiert und abstrahiert sind, was gestattet große Mengen von Signalen zu zeigen und menschliche Fähigkeiten für den Abgleich von Mustern zu nutzen. Sobald eine Abweichung A2, A3, A4 innerhalb des dargestellten Signals S2, S3, S4 vom Normalen im Sinne einer Fehlererkennung angezeigt wird, muss der Anlagenfahrer des Automatisierungssystems den Grund für diese Abweichung A2, A3, A4 analysieren. Für letzteres muss er die jeweiligen Prozess- und/oder Anlagengrößen analysieren. Daher ist zwischen der abstrakten Darstellung von Massendaten 10 im Sinne einer Fehlererkennung und einer Standard-Trend-Anzeige als Fehlerdiagnose eine schnelle Verbindung erforderlich.

Erfindungsgemäß werden hierzu mehrere Trendanzeigen TA2, TA3, TA4 rund um die Massendaten-Darstellung 10 platziert. So ist es sehr einfach, ein Element A2, A3, A4 aus der Massendaten-Darstellung 10 auszuwählen und die hierauf bezogene Prozessgröße in einer der Trendanzeigen TA2, TA3, TA4 darzustellen.

Nun sollen nochmals die Vorteile der Erfindung herausgestellt werden, die auf den verschiedenen Darstellungsvarianten und deren Kombinationen beruhen.

Die beschriebene Technik erlaubt es, so systematisch Displays aufzubauen, die einen vollständigen Überblick über den Prozess bieten und gleichzeitig die Anzahl der angezeigten Prozess- und/oder Anlagedaten möglichst gering halten. Dabei werden Unruhe und Unregelmäßigkeiten in der Anzeige während des normalen Betriebs minimiert. Die Anlagenfahrer sind von lästigen Aufgaben wie der Beurteilung, ob ein Signal immer noch still ist oder noch ähnlich genug im Vergleich mit anderen Signalen, entlastet. Schwingungen bei den Prozess- und/oder Anlagengrößen werden explizit sichtbar gemacht, ohne dass die sichtbaren Muster in der Gesamtdarstellung bei der Darstellung von Massendaten relevant beeinflusst werden. Die Verbindung zwischen einer Fehlererkennung, unterstützt von einer abstrakten und normierten Darstellung und der Fehlerdiagnose, unterstützt von Standard-Trend-Anzeigen, wird durch eine neue Kombination von abstrakt/normierter Anzeige der Massendaten und der Standard-Trend-Anzeigen einzelner Prozess- und/oder Anlagegrößen erreicht.

## Patentansprüche

1. Verfahren zur intelligenten Visualisierung bei der Überwachung von Prozessund/oder Anlagedaten bei einem technischen Prozess oder beim Betrieb einer technischen Anlage, **dadurch gekennzeichnet, dass** das Verhalten der Prozess- und/oder Anlagedaten in der Vergangenheit analysiert und für eine optimierte Visualisierung genutzt wird, wobei mittels kontinuierlich laufender Online-Algorithmen Abweichungen von historisch beobachteten Signalmustern erkannt und entsprechend hervorgehoben werden, indem
• eine Vielzahl von stillen Signalen (S1, S2, S3, S4) in einer einzigen Ansicht bzw. Darstellungsform (11) zusammengefasst werden, wobei Prozess- und/oder Anlagedaten, die sich für einen gewissen, vorab definierten Zeitraum in der Vergangenheit nicht geändert haben, als stille Signale (S1, S2, S3, S4) bezeichnet werden,
• eine Varianzüberwachung zur Online-Überwachung der stillen Signale (S1, S2, S3, S4) durchgeführt wird und
• im Falle, dass eine geschätzte Varianz einer Prozess- und/oder Anlagegröße einen vorkonfigurierten Schwellwert überschreitet, das betreffende Signal "aktiv" gesetzt wird, und dieses Signal hervorgehoben angezeigt und/oder gemeldet wird.

2. Verfahren nach Anspruch 1, **dadurch gekennzeichnet, dass** die Prozessund/oder Anlagedaten Messwerte, Prozessgrößen und/oder Zustandsmeldungen der technischen Anlage oder des technischen Prozesses umfassen.

3. Verfahren nach einem der vorherigen Ansprüche, **dadurch gekennzeichnet, dass** die Prozess- und/oder Anlagedaten Massedaten, also eine Vielzahl von Prozess- und/oder Verfahrensdaten, umfassen.

4. Verfahren nach einem der vorherigen Ansprüche, **dadurch gekennzeichnet, dass** eine Ähnlichkeits-Metrik definiert wird und dass ein Algorithmus zur Auswertung der Ähnlichkeits-Metrik für alle Prozess- und/oder Anlagedaten angewendet wird, wobei die Prozess- und/oder Anlagedaten, die in der Vergangenheit als ausreichend ähnlich ermittelt worden sind, in einer einzigen Ansicht zusammengefasst angezeigt werden.

5. Verfahren nach Anspruch 4, **dadurch gekennzeichnet, dass** die Ähnlichkeits-Metrik regelmäßig online mittels eines Auswertemoduls (22) überwacht und ausgewertet wird und Signale, die nicht mehr den Ähnlichkeits-Kriterien entsprechen, automatisch in einer separaten Darstellung bereitgestellt und/oder angezeigt werden.

6. Verfahren nach einem der vorherigen Ansprüche, **dadurch gekennzeichnet, dass** die ungefilterten Rohsignale der Prozess- und/oder Anlagedaten online bezüglich dominanter Schwingungen mittels eines Analysemoduls analysiert werden.

7. Verfahren nach Anspruch 6, **dadurch gekennzeichnet, dass** detektierte dominante Schwingungen von dem Signal abgezogen und separat ausgewiesen werden.

## Claims

1. Method for the intelligent visualization in the monitoring of process and/or system data in a technical process or in the operation of a technical system, **characterized in that** the behavior of the process and/or system data in the past is analyzed and used for an optimized visualization, wherein deviations from historically observed signal patterns are detected and correspondingly highlighted by means of continuously running online algorithms, by
• combining a plurality of silent signals (S1, S2, S3, S4) in a single view or representation form (11), wherein process and/or system data that has not changed for a certain predefined period of time in the past is referred to as silent signals (S1, S2, S3, S4),
• variance monitoring for the online monitoring of the silent signals (S1, S2, S3, S4) is performed, and
• in the event that an estimated variance of a process and/or system variable exceeds a preconfigured threshold value, the relevant signal is set "active," and this signal is displayed in a highlighted manner and/or reported.

2. Method according to Claim 1, **characterized in that** the process and/or system data comprises measured values, process variables, and/or state messages of the technical system or the technical process.

3. Method according to one of the previous claims, **characterized in that** the process and/or system data comprises mass data, that is, a plurality of process and/or operating data.

4. Method according to one of the previous claims, **characterized in that** a similarity metric is defined and that an algorithm is used for evaluating the similarity metric for all process and/or system data, wherein the process and/or system data that has been determined to be sufficiently similar in the past is displayed as combined in a single view.

5. Method according to Claim 4, **characterized in that** the similarity metric is regularly monitored and evaluated online by means of an evaluation module (22), and signals that no longer meet the similarity criteria are automatically provided and/or displayed in a separate representation.

6. Method according to one of the previous claims, **characterized in that** the unfiltered raw signals of the process and/or system data are analyzed online with respect to dominant fluctuations by means of an analysis module.

7. Method according to Claim 6, **characterized in that** detected dominant fluctuations are subtracted from the signal and displayed separately.

## Revendications

1. Procédé de visualisation intelligente dans la surveillance de données de processus et/ou d'installation dans le cas d'un processus technique ou lors du fonctionnement d'une installation technique, **caractérisé en ce que** le comportement des données de processus et/ou d'installation dans le passé est analysé et est exploité pour une visualisation optimisée, dans lequel des écarts par rapport à des configurations de signaux observées dans le passé sont détectés au moyen d'algorithmes en ligne s'exécutant en continu et sont mis en valeur de manière correspondante,
- en rassemblant une pluralité de signaux fixes (S1, S2, S3, S4) dans une vue ou une forme de représentation (11) unique, dans lequel des données de processus et/ou d'installation qui ne se sont pas modifiées dans le passé au cours d'un intervalle de temps connu défini à l'avance, sont désignées comme étant des signaux fixes (S1, S2, S3, S4),
- en effectuant une surveillance de la variance pour surveiller en ligne les signaux fixes (S1, S2, S3, S4) et
- dans le cas où une variance estimée d'une grandeur de processus et/ou d'installation dépasse une valeur de seuil configurée à l'avance, le signal concerné est réglé à "actif" et ledit signal est affiché et/ou signalé en étant mis en valeur.

2. Procédé selon la revendication 1, **caractérisé en ce que** les données de processus et/ou d'installation comprennent des grandeurs de processus et/ou des messages d'état de l'installation technique ou du processus technique.

3. Procédé selon l'une quelconque des revendications précédentes, **caractérisé en ce que** les données de processus et/ou d'installation comprennent par conséquent une pluralité de données de processus et/ou de procédé.

4. Procédé selon l'une quelconque des revendications précédentes, **caractérisé en ce qu'**une métrique de ressemblance est définie et **en ce qu'**un algorithme d'évaluation de la métrique de ressemblance est appliqué à toutes les données de processus et/ou d'installation, dans lequel les données de processus et/ou d'installation qui ont été déterminées dans le passé comme étant sensiblement semblables, sont affichées de manière rassemblée dans une vue unique.

5. Procédé selon la revendication 4, **caractérisé en ce que** la métrique de ressemblance est surveillée et évaluée régulièrement en ligne au moyen d'un module d'évaluation (22) et des signaux qui ne correspondent plus aux critères de ressemblance sont automatiquement fournis et/ou affichés dans une représentation séparée.

6. Procédé selon l'une quelconque des revendications précédentes, **caractérisé en ce que** les signaux bruts non filtrés des données de processus et/ou d'installation sont analysés au moyen d'un module d'analyse en ce qui concerne des oscillations dominantes.

7. Procédé selon la revendication 6, **caractérisé en ce que** les oscillations dominantes détectées sont éliminées du signal et sont indiquées séparément.
